# EUROPEAN PATENT APPLICATION

(11) **EP 1 043 924 A2**
(43) Date of publication of application: **11.10.2000**
(21) Application number: 00302920.4
(22) Date of filing: 06.04.2000
(51) Int. Cl.: H05K 13/00

(54) **Product holding device**

(30) Priority: 07.04.1999 GB 9907773
(71) Applicant: Pace Micro Technology PLC, Shipley, West Yorkshire BD18 3LF (GB)
(72) Inventor: Everett, Steven, Saltaire, Shipley, BD18 3LF (GB)
(74) Representative: Wood, Graham

(57) **Abstract**

The invention relates to the ability for a holding device for a product such as a printed circuit board to be range taking in that it is capable of accommodating a range of printed circuit boards of differing dimensions. The holding device is adjustable in that there are provided clamping means which are selectively engageable in locating means provided on the holding device to suit the dimensions of a particular printed circuit board. This allows the holding device to be re-used which is contrary to what conventionally occurs.

## Description

The invention to which this invention relates is a device for holding a product such as a printed circuit board to be held in a position during the manufacturing process.

Typically, in the manufacture of many electrical/electronic products, the product components are assembled as a printed circuit board and each component assembly and manufacturing requirements analysed and assessed. The analysis and assessment can include the provision of holding devices for holding the product such as a printed circuit board in position while further manufacturing and assembly operations are performed on the same. In one arrangement, a holding device which is typically called a solder pallet in the trade, is provided which holds the product in position as components are soldered on the board in the required position and the required electrical connections are made. In large scale manufacturing the operations the size of the printed circuit board for the same type of product is known and a number of holding devices are manufactured to the particular size of the printed circuit board and to hold the same in position. Thus, it will be appreciated that conventionally, for each product which is to be manufactured a number of holding devices are manufactured specifically to take the particular size of printed circuit board for the manufacturing process of the product.

When a particular product manufacturing process comes to an end, perhaps due to the product being updated or different products being manufactured, the holding devices are conventionally discarded as they have been made for the purpose of holding a particular printed circuit board of a particular size in position and for a particular manufacturing process and as they have been manufactured for a particular size they cannot normally be re-used for the next product manufacturing process.

Typically a profiled recess is cut into the holding device to allow for the overhang of components connected to the printed circuit board and clamping means for clamping the product in position on the holding device are provided in fixed positions which are determined by the makeup and configuration of the printed circuit board to be held therein. Thus, by design, these holding devices will only suit one product.

When one considers that if 10 products are required to be manufactured at a time and for each product line there is required 100 holding devices at £68 per holding device, it will be seen that the cost for setting up holding devices for 10 products or product lines is £68,000. At present the holding devices of this value are discarded at the end of the manufacture of the products in question representing considerable wastage.

The aim of the present invention is to provide a holding device for a product and the holding device can be re-used and re-configured for different product types and sizes.

In a first aspect of the invention there is provided a holding device for a product to allow manufacturing and/or assembly operations to be performed on the product when held, characterised in that said holding device comprising a series of locating means at spaced locations around the periphery of the holding device for the selective location of a number of clamping means therein, the position of the clamping means on the holding device dependant on the dimensions of the product to be held in the holding device and the location of the clamping means being selectable with respect to the locating means to provide for the holding in position of a range of products of differing dimensions.

The invention therefore allows a range of products, typically printed circuit boards, to be clamped in position by allowing the selective engagement of the clamping means in the location means.

Typically the product which is held is a printed circuit board and the operation undertaken is the soldering of a series of components held on the board together on the reverse side of the board which is exposed for the soldering operation.

Typically, a lower number of clamping means are used than there are locating means on the holding device.

In one embodiment, the holding device can accept additional locating devices to allow the adjustment of the location of the clamping means for the product in the X and Y axes to allow the location and clamping in position of products of different sizes thereby allowing the holding device to be adaptable and re-used for different products manufacture.

The provision of the holding device according to the invention allows the set-up costs for a new product to be significantly reduced as the holding device according to the present invention can be re-used over a range of products and so new holding devices are not required to be generated each time a new product is to be manufactured and set-up times and change-over times are also reduced between products as the same holding devices can be simply reconfigured, rather than being required to be completely replaced.

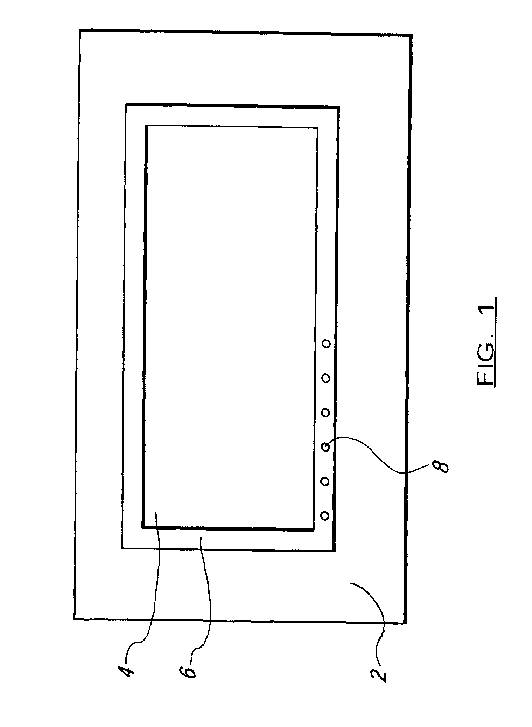

A specific embodiment of the invention is now described with respect to Figure 1, which illustrates a holding device according to the invention in one embodiment and wherein the holding device comprises a frame 2 surrounding an aperture 4 over which the majority of the surface of a printed circuit board, which is the product to be held in position in this case, sits. A recessed portion 6 is provided around the aperture so as to allow components which may protrude from the printed circuit board downwardly and outwardly, to be accommodated within the recessed area and without damage being caused to the components. This therefore leaves the rear surface of the board exposed and allows the soldering operation to take place to secure and connect the components on the printed circuit board.

In addition, there are provided a series of location means 8 at spaced intervals around the frame 2 of the holding device and it is envisaged that in one embodiment, 36 location means, each in the form of an aperture are provided in the recessed portion around the frame at spaced intervals. In another possible format the location means can be provided at different distances, spaced inwardly from the outer edge of the frame. The location means are provided to allow the selective location therein of clamping means, not shown, which clamping means are provided to connect with the printed circuit board and hence secure the printed circuit board in the required position. The selective positioning of the clamping means in the location means ensures that a range of printed circuit boards of differing dimensions can be accommodated by moving the clamping means to suit.

Thus, for example, the holding device can be manufactured with an aperture or recessed portion 4 which is large enough to accommodate the components of the largest envisaged printed circuit board which is to be held in the device. A series of location means are provided to allow the clamping means to be located therein and to hold the largest printed circuit board. However the selective repositioning of the clamping means in other location means provided on the holding device allows the selective location of smaller or differently shaped printed circuit boards on the holding device of the invention. It has been found that one form of holding device made in accordance with the invention allows the selective location of printed circuit boards having the dimensions of 325mm by 195mm; 281mm by 195mm; 253mm by 195mm; 244mm by 195mm and 325mm by 117mm and each of these boards, conventionally would require a separate set of holding devices to be manufactured.

A further feature of the holding device of the invention is that the outer size of the same can be kept to the standard dimensions, typically a length of 395mm and width of 305mm, so as to allow the holding device of the invention to be utilised in existing conveyor systems so that the holding device and product held therein pass along the same during the manufacturing/assembly operations.

It is envisaged that the holding device can be particularly advantageously formed from Thermoset polyester glass LRA but any suitable material can be used to suit particular requirements.

It should therefore be appreciated that the selective location of the clamping means in the location means provided allows a range of printed circuit boards to be located therein for the soldering process, thereby preventing the need to discard the holding devices after the cessation of manufacture of a particular product or printed circuit board.

## Claims

1. A holding device for a product to allow manufacturing and/or assembly operations to be performed on the product when held, characterised in that said holding device comprises a series of locating means at spaced locations around the periphery of the holding device for the selective location of a number of clamping means therein, the position of the clamping means on the holding device dependant on the dimensions of the product to be held in the holding device and the location of the clamping means being selectable with respect to the locating means to provide for the holding in position of a range of products of differing dimensions.

2. A holding device according to claim 1 characterised in that said device is used to hold a printed circuit board during the application of components to the board.

3. A holding device according to claim 2 characterised in that the components are attached to a first face of the board and soldered on the reverse face of the board which is exposed in the holding device to allow for the soldering operation.

4. A holding device according to claim 1 characterised in that a lower number of clamping means are used in the holding device than there are locating means.

5. A holding device according to claim 1 characterised in that the clamping means can be selectively positioned with the locating means to allow alteration of the clamping positions for printed circuit boards in X and/or Y axes.

6. A holding device according to claim 5 characterised in that the device can accept additional locating devices with which the clamping means are then engaged.
